# EUROPEAN PATENT APPLICATION

(11) **EP 4 354 494 A1**
(43) Date of publication of application: **17.04.2024**
(21) Application number: 22819332.2
(22) Date of filing: 20.05.2022
(51) Int. Cl.: H01L 21/67

(54) **SUBSTRATE TREATMENT APPARATUS**

(30) Priority: 11.06.2021 CN 202110653486
(71) Applicant: ACM Research (Shanghai) Inc., Shanghai 201203 (CN)
(72) Inventor: WANG, Hui, Shanghai 201203 (CN); LU, Yinxiao, Shanghai 201203 (CN); JIA, Shena, Shanghai 201203 (CN); TAO, Xiaofeng, Shanghai 201203 (CN); HAN, Yang, Shanghai 201203 (CN)
(74) Representative: Osha BWB
(86) International application number: PCT/CN2022/094164
(87) International publication number: WO 2022/257734

(57) **Abstract**

Disclosed in an embodiment of the present invention is a substrate heating apparatus, comprising a holding unit, a rotating unit, a heating unit, and a control unit. The heating unit comprises multiple fluid supply pipes and multiple groups of fluid cartridges, a substrate region heated by the fluid cartridges in the same group is a circular ring or a circle, and substrate regions heated by the fluid cartridges in different groups are not overlapped with each other and are concentric. The control unit can measure and adjust the temperatures of the substrate regions in real time. Because the structure of the heating unit is optimally designed and the control unit is added, the substrate heating apparatus of the present invention can adjust the temperatures of the regions on the substrate in real time, so that the temperatures of the regions on the substrate tend to be consistent, and high substrate heating efficiency and high temperature adjustment response speed are achieved. Further disclosed in another embodiment of the present invention is a substrate drying apparatus.

## Description

### BACKGROUND OF THE INVENTION

### 1. Field of the Invention

The present invention generally relates to the field of semiconductor equipment, and more particularly to a substrate treatment apparatus.

### 2. The Related Art

In the manufacturing process of integrated circuits, the wet process of substrates is an important process that affects product yield. Among them, the single piece wet process has been increasingly widely used due to its good uniformity, repeatability, and stability.

In the substrate drying process, the substrate is first rinsed with a rinsing liquid to form a film of rinsing liquid on the substrate, and then rotationally dried. If water is used as the rinsing liquid, the surface tension of the water film generated at the contact position of the water pattern is too high, which may easily cause the pattern on the surface of the substrate to collapse. Therefore, for substrates with fine patterns, IPA, which has a low surface tension, is usually used as the rinsing liquid. Since the heated IPA has a lower surface tension, further reducing the possibility of pattern collapse, the existing substrate drying apparatus is provided with a heating module to heat the substrate. As the process requirements become higher and higher, the existing heating module can't meet the requirements of the substrate surface temperature uniformity and heating efficiency.

### SUMMARY

An object of the present invention is to propose a substrate treatment apparatus for the above-mentioned technical problems. In the substrate drying process, the heating efficiency is improved, and the temperatures at various locations on the substrate are close, achieving a uniform drying effect.

In order to achieve the above object, one embodiment of the present invention proposes a substrate heating apparatus, comprising:
a holding unit, configured to hold the substrate in a horizontal state;
a rotating unit, configured to drive the holding unit and the substrate to rotate around a vertical line passing through the center of the substrate;
a heating unit, comprising a plurality of fluid supply pipes and a plurality of groups of fluid cartridges, said fluid cartridges being distributed parallel to the substrate, the fluid cartridges configured to heat a bottom surface of the substrate, the bottoms of the fluid cartridges connected to corresponding fluid supply pipes, the top of the fluid cartridges provided with a plurality of outlet holes, the region of the substrate heated by the same group of fluid cartridges being a circular ring or a circle; and
a control unit, comprising a controller, a plurality of temperature sensors and a plurality of mass flow meters, said temperature sensors being provided on the holding unit and configured to detect the temperature of the substrate region heated by a corresponding group of fluid cartridges, said mass flow meters being provided on corresponding fluid supply pipes, and said controller being connected to each of the temperature sensors and the mass flow meters.

Another embodiment of the present invention proposes a substrate drying apparatus, comprising:
a holding unit, configured to hold the substrate in a horizontal state;
a rotating unit, configured to drive the holding unit and the substrate to rotate around a vertical line passing through the center of the substrate;
a heating unit, comprising a plurality of fluid supply pipes and a plurality of groups of fluid cartridges, said fluid cartridges being distributed parallel to the substrate, the fluid cartridges being configured to heat a bottom surface of the substrate, the bottoms of the fluid cartridges being connected to corresponding fluid supply pipes, the top of the fluid cartridges being provided with a plurality of outlet holes, the region of the substrate heated by the same group of fluid cartridges being a circular ring or a circle;
a control unit, comprising a controller, a plurality of temperature sensors and a plurality of mass flow meters, said temperature sensors being provided on the holding unit and configured to detect the temperature of the substrate region heated by the corresponding group of fluid cartridges, said mass flow meters being provided on the corresponding fluid supply pipes, and said controller being connected to the respective temperature sensors and the mass flow meters; and
an IPA supply unit, configured to spray an IPA drying fluid onto the surface of the substrate.

The substrate treatment apparatus of the present invention optimizes the design of the structure of the heating unit and incorporates the control unit, which can detect and regulate the temperatures of various regions on the substrate in real time, so as to make the temperatures of the various regions on the substrate uniform, and to achieve a high substrate heating efficiency and temperature regulation response speed.

### BRIEF DESCRIPTION OF THE DRAWINGS

FIG. 1 illustrates a schematic diagram of a cross-sectional structure of a substrate heating apparatus of an embodiment 1 of the present invention.
FIG. 2 illustrates a schematic diagram of the shape of a fluid cartridge in the embodiment 1 of the present invention.
FIG. 3 illustrates a schematic diagram of a three-dimensional structure of a fluid supply pipe of the embodiment 1 of the present invention.
FIG. 4 illustrates a schematic diagram of a main view structure of the fluid supply pipe and the fluid cartridge of the embodiment 1 of the present invention.
FIG. 5 illustrates a cross-sectional schematic diagram of the fluid cartridge of the embodiment 1 of the present invention.
FIG. 6 illustrates a schematic diagram of a three-dimensional structure of the fluid cartridge and a positioning pin of the embodiment 1 of the present invention.
FIG. 7 illustrates a schematic diagram of the shape of a fluid cartridge in an embodiment 2 of the present invention.
FIG. 8 illustrates a schematic diagram of the shape of a fluid cartridge in an embodiment 3 of the present invention.
FIG. 9 illustrates a schematic diagram of the shape of a fluid cartridge in an embodiment 4 of the present invention.
FIG. 10 illustrates a schematic diagram of a structure of a substrate drying device of an embodiment 6 of the present invention.

### DETAILED DESCRIPTION OF EMBODIMENTS

In order to explain the technical content, structural features, objects and effects of the present invention in detail, the following will be described in detail in combination with the embodiments and drawings.

### Embodiment 1

The present embodiment provides a substrate heating apparatus, including a holding unit 101, a rotating unit 102, a heating unit 103, and a control unit 104.

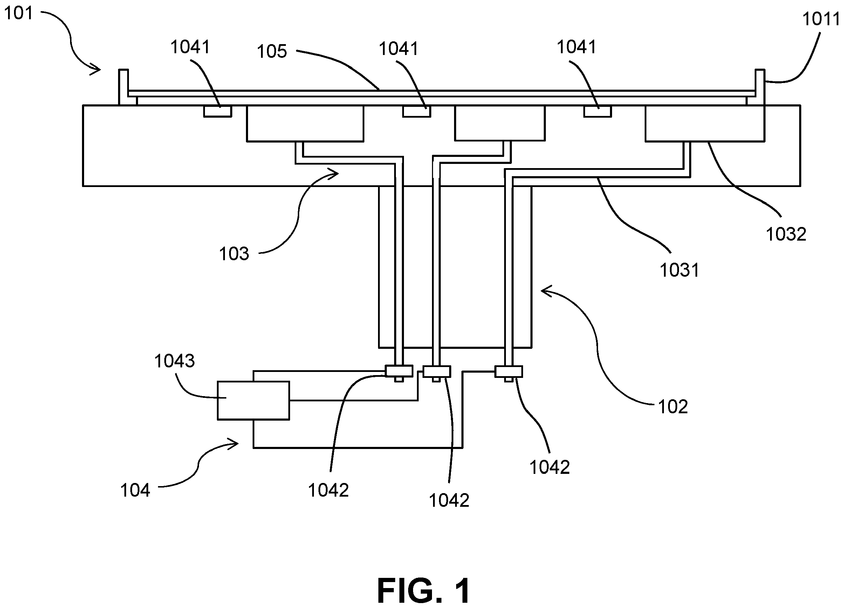

FIG. 1 illustrates a schematic diagram of a cross-sectional structure of the substrate heating apparatus, from which it can be seen the approximate position and connection relationship of each unit in the substrate heating apparatus.

The holding unit 101 is used to hold the substrate 105 in a horizontal state, and includes a plurality of positioning pins 1011 disposed around the substrate 105. A lower portion of the positioning pins 1011 supports the substrate 105 from a bottom portion of the periphery of the substrate 105, and an upper portion of the positioning pins 1011 clamps the substrate 105 from the edge of the substrate 105. The bottom portion of the positioning pins 1011 is connected to a driving mechanism (not shown in the figure) such as a cylinder, and under the action of the driving mechanism, the positioning pin 1011 is moved away from the substrate 105 to release the substrate 105, or is moved close to the substrate 105 to clamp the substrate 105.

The rotating unit 102 is located at the bottom of the holding unit 101 for driving the holding unit 101 and the substrate 105 to rotate around a vertical line passing through the center of the substrate 105. The interior of the rotating unit 102 is hollow to accommodate some non-rotating parts.

The heating unit 103 includes three fluid supply pipes 1031 and three groups of fluid cartridges 1032.

The control unit 104 includes three temperature sensors 1041, three mass flow meters 1042, and a controller 1043. The temperature sensors 1041 can be disposed on the holding unit 101, and each temperature sensor 1041 corresponds to a group of fluid cartridges 1032 to detect the temperature of the substrate region heated by the group of fluid cartridges 1032. Each mass flow meter 1042 is disposed on the corresponding fluid supply pipe 1031. The controller 1043 is connected to each of the temperature sensors 1041 and the mass flow meters 1042.

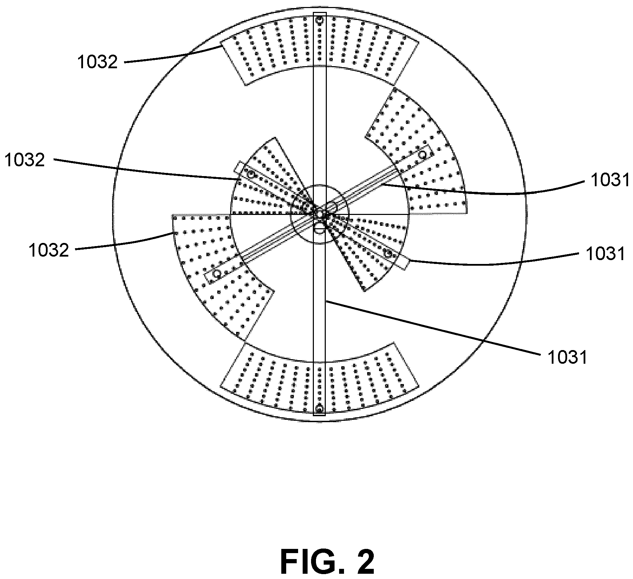

As shown in FIG. 2, in the substrate heating apparatus of the present embodiment, there are three groups of fluid cartridges 1032, which are distributed parallel to the substrate 105, and the number of each group of fluid cartridge 1032 is two. Each fluid cartridge 1032 has an axisymmetric shape, and the axis of symmetry of the fluid cartridge 1032 intersects perpendicularly with the axis of rotation of the substrate, and for the two fluid cartridges 1032 in the same group, the angle between the two axes of symmetry is 180°. During the process, the substrate 105 is rotating, and when the substrate 105 rotates one revolution, the substrate region heated by the same group of fluid cartridges 1032 is a circular ring or circle, and the substrate regions heated by the different groups of fluid cartridges 1032 preferably do not overlap with each other and are concentric. Obviously, the fluid cartridge 1032 closest to the center may be C-shaped or fan-shaped, and the remaining fluid cartridges 1032 are C-shaped. The C-shape described above can be the remaining part of a circular ring after cutting off a segment. The fluid cartridge 1032 closest to the center can be provided in a C-shape because heat is easily lost at the edge of the substrate 105 and less heat is lost in the center region of the substrate 105.

When the fluid cartridge 1032 closest to the center is C-shaped, the substrate region heated by the group of fluid cartridges 1032 is a circular ring. When the fluid cartridge 1032 closest to the center is fan-shaped, the substrate region heated by the group of fluid cartridges 1032 is a circle.

After the substrate regions heated by the three groups of fluid cartridges 1032 are combined, they form a circular ring or circle.

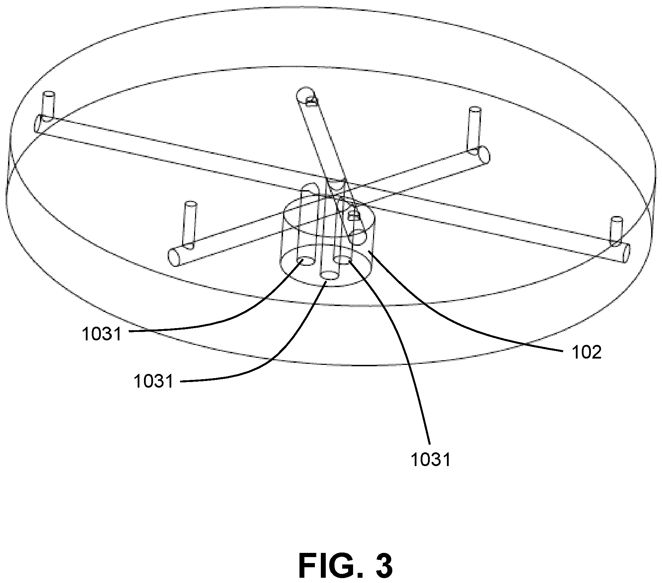

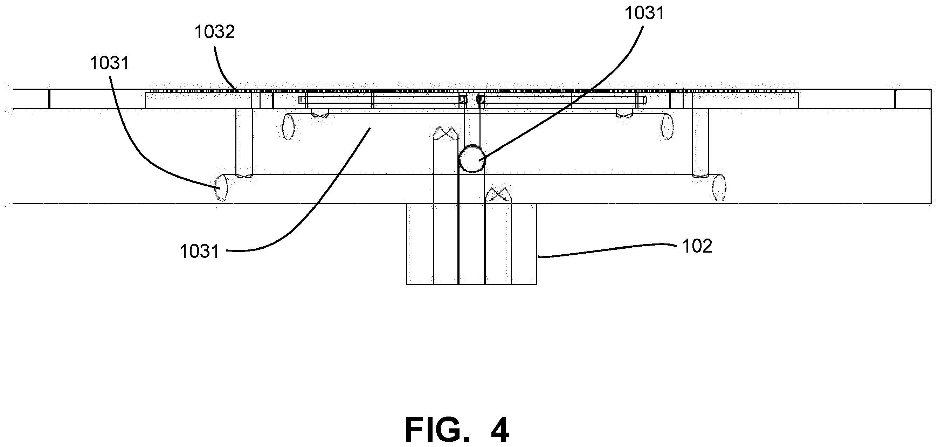

Referring to FIG. 3, there are three fluid supply pipes 1031, each of which corresponds to a group of fluid cartridges 1032. The fluid supply pipes 1031 pass upwardly through the rotating unit 102, protruding out of an opening at the top of the rotating unit 102, and then each of the fluid supply pipes 1031 is divided into two paths, extending radially along the substrate 105 and finally connected upwards to the corresponding fluid cartridges 1032. In order to clearly show the structure and position of each fluid supply pipe 1031, the fluid cartridge 1032 is not shown in FIG. 3. FIG. 4 illustrates the structure of the fluid supply pipe 1031 in a horizontal view, with the position of the fluid cartridge 1032 shown in FIG. 4.

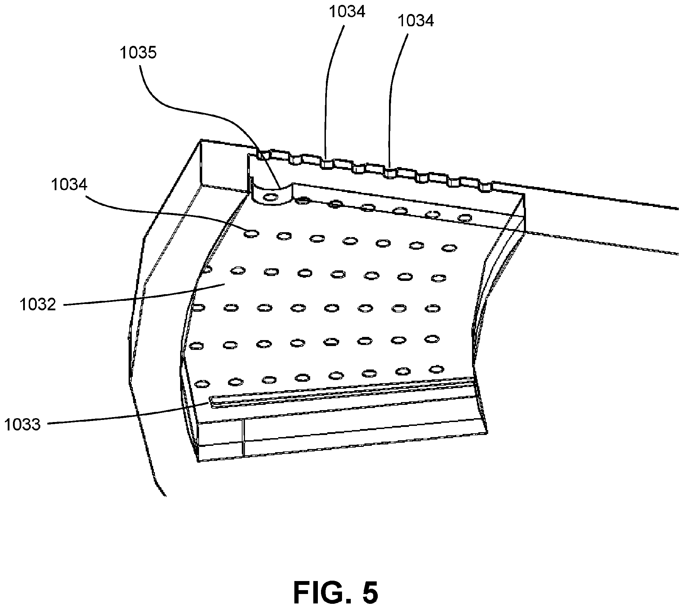

In this embodiment, the fluid cartridge 1032 is a cavity in a plate member, and all of the fluid cartridges 1032 are located in the same circular plate member, which facilitates the manufacturing of heating unit. FIG. 5 illustrates a schematic diagram of the cross-sectional structure of a fluid cartridge 1032 furthest from the center of the plate member, and in order to observe the structure of the top of the fluid cartridge 1032, the bottom of the fluid cartridge 1032 is made transparent in FIG. 5. As shown in FIG. 5, an electric heating wire 1033 is embedded in the top wall of the fluid cartridge 1032, a plurality of small outlet holes 1034 are provided in the top wall of the fluid cartridge 1032, and a large inlet hole 1035 is provided in the bottom wall of the fluid cartridge 1032. The material of the plate member may be plastic, ceramic, and the like.

In another embodiment, the fluid cartridges 1032 may also be individual cartridges.

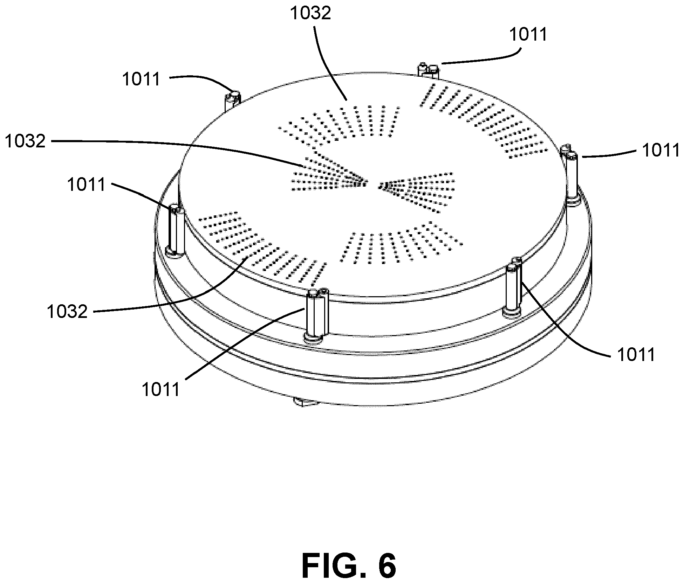

FIG. 6 illustrates the position of the fluid cartridges 1032 and the positioning pins 1011 in the substrate heating apparatus of this embodiment, with sit positioning pins surrounding the edges of the fluid cartridges 1032, and the six fluid cartridges 1032 all being C-shaped. If the plate member is divided into six equal fan-shaped regions, each fluid cartridge 1032 is located in one fan-shaped region.

In operation, the holding unit 101 clamps the substrate 105, and the rotating unit 102 drives the holding unit 101 and the substrate 105 to rotate. The heated fluid enters the corresponding fluid cartridge 1032 through the fluid supply pipe 1031, and then is ejected vertically upwardly from the outlet hole 1034 to heat the bottom of the substrate 105. As the fluid cartridge 1032 is provided with the electric heating wire, a higher temperature can be maintained in the fluid cartridge 1032, which can reduce the heat loss of the fluid in the transmission process and improve the heating efficiency of the fluid to the substrate 105.

By adjusting the temperature of the fluid supplied to each fluid supply pipe 1031, the temperature of the fluid in the corresponding fluid cartridge 1032 can be adjusted, thereby adjusting the temperature of different regions at the bottom of the substrate 105.

In addition, each temperature sensor 1041 detects the temperature of the corresponding substrate region and sends the temperature information to the controller 1043 in real time, and the controller 1043 adjusts the respective mass flow meter 1042 based on the returned temperature information so that the temperatures of the various regions on the substrate 105 tend to be consistent. For example, the higher the fluid flow rate, the more significant the thermal convection is and the higher the temperature of the substrate 105. Since the fluid flow rate can be changed quickly, a faster temperature regulation response can be achieved compared to regulating the temperature of the fluid itself.

In some embodiments, the outlet holes 1034 on the fluid cartridges 1032 at different locations have different densities. For example, the closer the fluid cartridge 1032 is to the edge of the substrate 105, the higher the density of the outlet holes 1034.

The fluid cartridges 1032 may also be provided in four groups or five groups, and accordingly, the number of fluid supply pipes 1031 is four or five, the number of temperature sensors 1041 is four or five, and the number of mass flow meters 1042 is four or five.

The fluid may be a gas such as nitrogen or a liquid.

### Embodiment 2

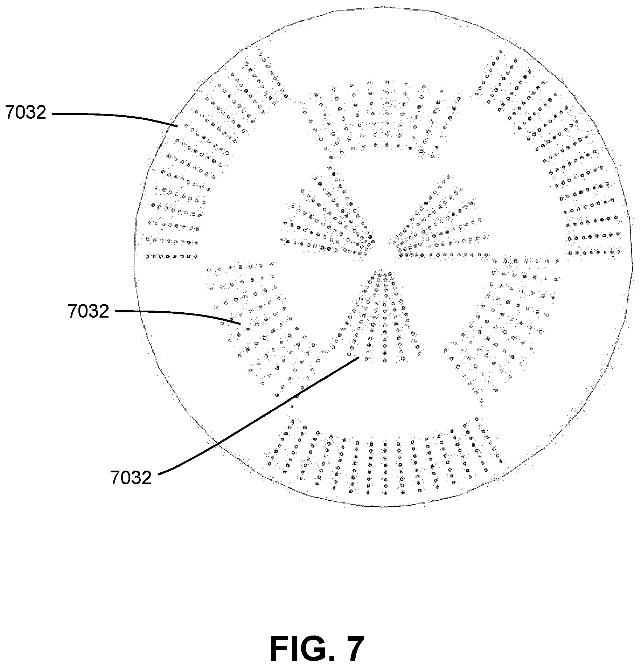

The present embodiment provides a substrate heating apparatus, the structure of which is essentially the same as that of the substrate heating apparatus in Embodiment 1, with the difference that, as shown in FIG. 7, the number of each group of fluid cartridges 7032 is three. Accordingly, after the fluid supply pipe protrudes from the opening at the top of the rotating unit, it is then divided into three paths, extending radially along the substrate, and is finally connected upwardly to the corresponding fluid cartridge 7032.

The remaining structures are the same as the embodiment 1.

### Embodiment 3

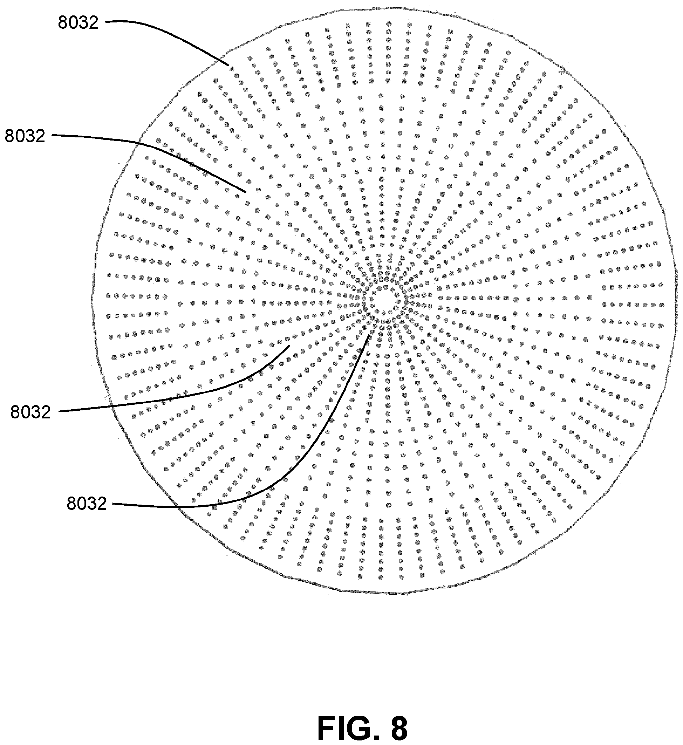

The present embodiment provides a substrate heating apparatus, the structure of which is essentially the same as the structure of the substrate heating apparatus in Embodiment 1, with the difference that, as shown in FIG. 8, the heating unit comprises four fluid cartridges 8032, each of which is annular and concentrically disposed. Accordingly, after the fluid supply pipe protrudes from the opening at the top of the rotating unit, it is then divided into several paths, extending radially along the substrate, and is finally connected upwardly to the corresponding fluid cartridge 8032The number of the fluid cartridges 8032 may also be five.

The remaining structures are the same as the embodiment 1.

### Embodiment 4

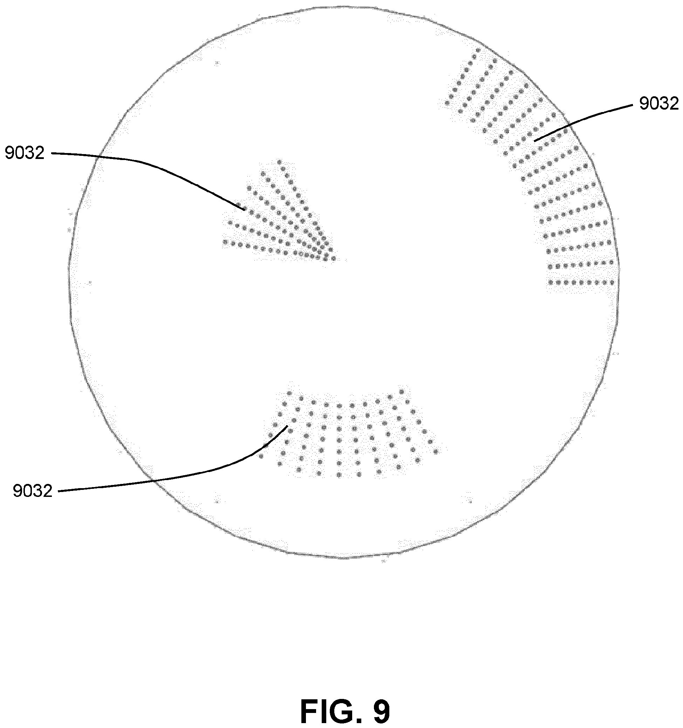

The present embodiment provides a substrate heating apparatus, the structure of which is essentially the same as the structure of the substrate heating apparatus in Embodiment 1, with the difference that, as shown in FIG. 9, the heating unit comprises three fluid cartridges 9032, with the outer two fluid cartridges 9032 being C-shaped and the inner fluid cartridge 9032 being fan-shaped. After the substrate regions heated by the three fluid cartridges 1032 are combined, they form a circle. Accordingly, after the fluid supply pipe protrudes from the opening at the top of the rotating unit, it is extending radially along the substrate, and is finally connected upwardly to the corresponding fluid cartridge 9032.

The remaining structures are the same as the embodiment 1.

### Embodiment 5

This embodiment provides a substrate heating apparatus, the structure of which is essentially the same as the structure of the substrate heating apparatus in embodiment 1, with the difference that the fluid cartridge is not provided with an electric heating wire, and in order to prevent too much heat from being lost during the fluid transmission process, the fluid cartridge and the fluid supply pipe may be selected from materials with poor thermal conductivity, such as fiberglass, or an air compartment tube may be used to make the fluid supply pipe, or the heating unit may be covered with an thermal insulation material.

The remaining structures are the same as the embodiment 1.

### Embodiment 6

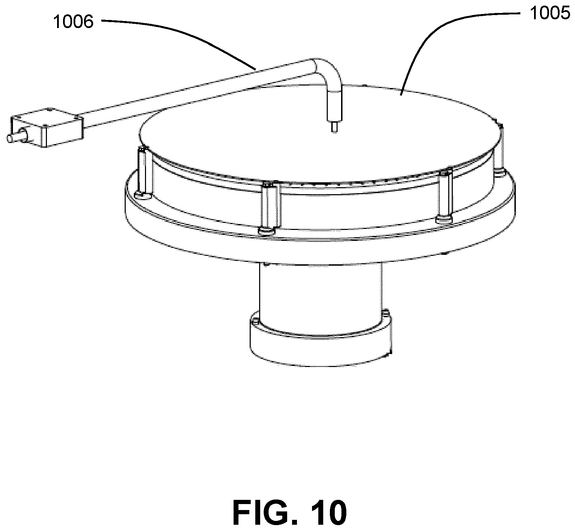

As shown in FIG. 10, the present embodiment provides a substrate drying apparatus comprising all the structures of the substrate heating apparatus of the embodiment 1, and in addition, further including an IPA supply unit 1006. In operation, the IPA supply unit 1006 sprays IPA drying liquid on the surface of the substrate 1005, and by centrifugal force generated by rotation of the substrate 1005, the IPA drying liquid is thrown out of the surface of the substrate 1005, and the distance between the nozzle of the IPA drying liquid and the center of the substrate can be changed to dry the various regions of the substrate 1005. Uniform heating of the substrate by the heating unit reduces the surface tension of the IPA liquid and reduces the risk of collapse of the fine patterns on the surface of the substrate 1005.

In summary, the present invention, by means of the above-described embodiments and related illustrations, has specifically and in detail disclosed the relevant technology, so that those skilled in the art can be implemented accordingly. The above-mentioned embodiments are only used to illustrate the present invention, and are not used to limit the present invention, the scope of rights of the present invention shall be defined by the Claims of the invention. Changes in the number of components or substitution of equivalent components as described herein shall still be within the scope of the present invention.

## Claims

1. A substrate heating apparatus, comprising:
a holding unit, configured to hold the substrate in a horizontal state;
a rotating unit, configured to drive the holding unit and the substrate to rotate around a vertical line passing through the center of the substrate;
a heating unit, comprising a plurality of fluid supply pipes and a plurality of groups of fluid cartridges, said fluid cartridges distributed parallel to the substrate, the fluid cartridges configured to heat a bottom surface of the substrate, the bottom of the fluid cartridges connected to corresponding fluid supply pipes, the top of the fluid cartridges provided with a plurality of outlet holes, and the region of the substrate heated by the same group of fluid cartridges being a circular ring or a circle; and
a control unit, comprising a controller, a plurality of temperature sensors and a plurality of mass flow meters, said temperature sensors being provided on the holding unit and configured to detect the temperature of the substrate region heated by a corresponding group of fluid cartridges, said mass flow meters being provided on corresponding fluid supply pipes, and said controller being connected to each of the temperature sensors and the mass flow meters.

2. The substrate heating apparatus according to claim 1, wherein the substrate regions heated by different groups of fluid cartridges do not overlap with each other and are concentric.

3. The substrate heating apparatus according to claim 1, wherein the number of fluid cartridges in each group is two or more, the fluid cartridge closest to the center being C-shaped or fan-shaped, and the remaining fluid cartridges being C-shaped.

4. The substrate heating apparatus according to claim 1, wherein the number of fluid cartridges in each group is one, the fluid cartridge closest to the center being C-shaped, annular or fan-shaped, and the remaining fluid cartridges being C-shaped or annular.

5. The substrate heating apparatus according to claim 1, wherein said rotating unit is hollow, and said fluid supply pipes pass upwardly through the rotating unit and protrude out of an opening at the top of the rotating unit, and then extends radially along the substrate, and finally connects upwardly to the corresponding fluid cartridge.

6. The substrate heating apparatus according to claim 1, wherein all the fluid cartridges are located in the same circular plate member, the fluid cartridges being cavities in the plate member.

7. The substrate heating apparatus according to claim 1, wherein said fluid cartridges are embedded with an electric heating wire.

8. The substrate heating apparatus according to claim 1, wherein the outlet holes on the fluid cartridges at different positions have different densities.

9. The substrate heating apparatus according to claim 1, wherein said fluid cartridges and fluid supply pipes are made of thermal insulation material.

10. A substrate drying apparatus, comprising:
a holding unit, configured to hold the substrate in a horizontal state;
a rotating unit, configured to drive the holding unit and the substrate to rotate around a vertical line passing through the center of the substrate;
a heating unit, comprising a plurality of fluid supply pipes and a plurality of groups of fluid cartridges, said fluid cartridges distributed parallel to the substrate, the fluid cartridges configured to heat a bottom surface of the substrate, the bottom of the fluid cartridges connected to corresponding fluid supply pipes, the top of the fluid cartridges provided with a plurality of outlet holes, and the region of the substrate heated by the same group of fluid cartridges being a circular ring or a circle;
a control unit, comprising a controller, a plurality of temperature sensors and a plurality of mass flow meters, said temperature sensors being provided on the holding unit and configured to detect the temperature of the substrate region heated by a corresponding group of fluid cartridges, said mass flow meters being provided on corresponding fluid supply pipes, and said controller being connected to each of the temperature sensors and the mass flow meters; and
an IPA supply unit, configured to spray an IPA drying fluid onto a surface of the substrate.
